# EUROPÄISCHE PATENTSCHRIFT

(11) **EP 1 469 711 B1**
(45) Veröffentlichungstag und Bekanntmachung des Hinweises auf die Patenterteilung: **20.04.2011**
(21) Anmeldenummer: 04003941.4
(22) Anmeldetag: 20.02.2004
(51) Int. Cl.: B60R 16/02, H05K 7/20, H05K 5/00

(54) **Gehäuse mit Kühlung für elektronische Steuergeräte, insbesondere in Kfz**
Housing with cooler for electronic control devices particularly in vehicle
Boîtier avec refroidisseur pour des appareils électroniques de commande dans une automobile en particulier

(30) Priorität: 17.04.2003 DE 10317705
(43) Veröffentlichungstag der Anmeldung: 20.10.2004
(73) Patentinhaber: ROBERT BOSCH GMBH, 70442 Stuttgart (DE)
(72) Erfinder: Schweinbenz, Jochen, 70469 Stuttgart (DE); Schiefer, Peter, 74199 Unterheinriet (DE); Schmidt, Dirk, 70771 Leinfelden-Echterdingen (DE); Haehnel, Gero, 70794 Filderstadt (DE)

(56) Entgegenhaltungen:
- EP-A- 0 309 986
- EP-A- 0 968 885
- GB-A- 2 352 092
- US-A1- 2002 166 519

## Beschreibung

### STAND DER TECHNIK

Die Erfindung betrifft ein Gehäuse für elektronische Steuergeräte, insbesondere in Kraftfahrzeugen, mit einem Bodenabschnitt zur Befestigung der elektronischen Steuergeräte und mit einer Kühleinrichtung, durch die mittels einer durchströmenden Flüssigkeit Wärme aus dem Gehäuse abführbar ist.

Für den einwandfreien Betrieb elektronischer Steuergeräte ist deren Kühlung unerlässlich. Dies gilt um so mehr für solche elektronischen Steuergeräte, die in Bereichen mit hoher Temperaturbelastung, wie beispielsweise in einem Kraftfahrzeugmotorraum, betrieben werden. Wegen dieser besonderen Temperaturbedingungen war es bisher üblich, elektronische Steuergeräte an thermisch weniger belasteten Punkten im Kraftfahrzeug oder auf separaten Wärmesenken zu montieren.

Ein Gehäuse der eingangs genannten Art ist bereits in der EP 0 968 885 A2 offenbart. Bei diesem vorbekannten Gehäuse ist der Bodenabschnitt mit einer Ausnehmung zum Einsetzen eines elektronischen Steuergeräts versehen, wobei die Kühleinrichtung mit Kühlkanälen gebildet ist, die im Bereich von drei Seitenrändern der Ausnehmung offen eingeformt und mittels eines separaten Deckels verschlossen sind. Für die Herstellung dieser Kühlkanäle sind zusätzliche Verfahrensschritte, wie das Aufschweißen eines Deckels oder das dichtende Aufschrauben eines Deckels, erforderlich. Als nachteilig ist bei diesem vorbekannten Gehäuse weiterhin anzusehen, dass der Wirkungsgrad der Kühlung unzureichend ist, weil eine Wärmeabfuhr im wesentlichen nur an drei Randseiten der Ausnehmung für das elektronische Steuergerät erfolgt.

Aus der US 2002/166519 A1 ist weiterhin ein Gehäuse für ein elektronisches Steuergerät bekannt, das einen Bodenabschnitt und einen Deckelabschnitt aufweist, wobei auf einer Fläche des Deckelabschnitts ein Kühleinrichtung_in Form eines Kühlkanals angeordnet ist. Der Kühlkanal ist dabei in einem separaten Metallteil ausgebildet, das auf der Fläche des Deckelabschnitts angebracht ist. Der Kühlkanal wird von Kühlwasser durchströmt, das Wärme aus dem Gehäuse abführt.

Der Erfindung liegt demgemäss die Aufgabe zugrunde, ein Gehäuse der eingangs genannten Gattung verfügbar zu machen, das die Vorzüge einer Herstellung mit geringem Fertigungsaufwand mit denen einer hohen Kühlleistung verbindet.

Erfindungsgemäß wird diese Aufgabe durch die im Patentanspruch 1 genannten Merkmale gelöst.

Bevorzugte Merkmale, die die Erfindung vorteilhaft weiterbilden, sind den nachgeordneten Patentansprüchen zu entnehmen.

Aufgrund der erfindungsgemäßen Konzeption wird vorteilhaft ein Gehäuse mit einer integrierten Kühleinrichtung verfügbar gemacht, das den Betrieb elektrischer Steuergeräte in Bereichen mit hoher Temperaturbelastung, beispielsweise im Motorraum eines Kraftfahrzeugs, ermöglicht. Durch die Integration der Kühleinrichtung in dem Bodenabschnitt liegen für den Wärmeabtransport ideale Wärmeübergangsverhältnisse zwischen dem elektronischen Steuergerät und der Kühleinrichtung vor, wodurch eine besonders effektive Kühlung erreicht werden kann.

Gleichzeitig bietet die erfindungsgemäße Lösung auch vorteilhaft die Voraussetzung dafür, eine Kühlkanalgeometrie so weit zu vereinfachen, dass der Bodenabschnitt in einem Schritt, beispielsweise durch Fertigguss, hergestellt werden kann.

Die Fertigungskosten lassen sich vorteilhaft durch Reduzierung und Vereinheitlichung der zur Herstellung notwendigen Schritte verringern, und die Konstruktion von Gehäusen für elektronische Steuergeräte lässt sich flexibel und mit einer Leistungsverbesserung wegen höherer Wärmeabfuhr realisieren.

Nachfolgend wird ein Ausführungsbeispiel der vorliegenden Erfindung unter Bezugnahme auf die beigefügten Figuren näher erläutert. Es zeigen:
- Figur 1: eine perspektivische Draufsicht auf einen Bodenabschnitt eines Gehäuses für elektronische Steuergeräte;
- Figur 2: den Bodenabschnitt von Figur 1 perspektivisch von unten; und
- Figur 3: einen Schnitt entlang der Schnittlinie III-III in Figur 1.

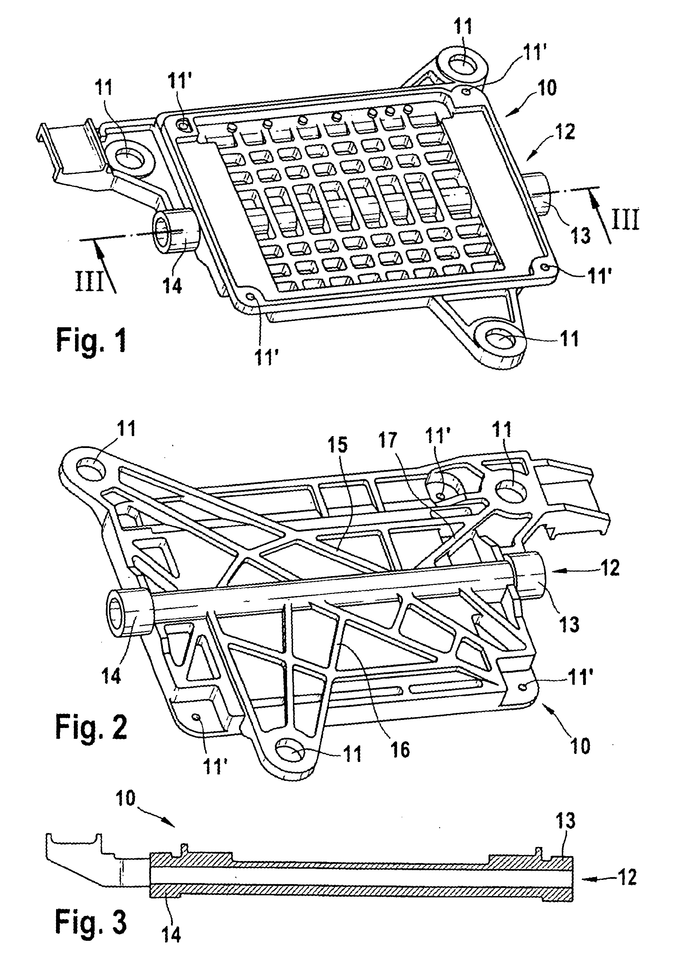

In den Figuren 1 bis 3 ist von dem Gehäuse für elektronische Steuergeräte, insbesondere in Kraftfahrzeugen, nur ein annähernd rechteckförmig gestalteter Bodenabschnitt 10 dargestellt, der drei fahrzeugseitige Aufnahmepunkte 11 und vier Durchgangsbohrungen 11' aufweist, die sich in den vier Ecken zur Verschraubung mit einem nicht dargestellten Deckel sowie einer nicht dargestellten Leiterplatte befinden. Der Bodenabschnitt 10 besitzt mittig als Kühleinrichtung einen Kühlkanal 12, der geradlinig ausgebildet ist und einstückig mit dem Bodenabschnitt 10 hergestellt ist. Der Kühlkanal 12 mündet an gegenüberliegenden Seiten des Bodenabschnitts 10 in Anschlussgewindestutzen 13 bzw. 14, an die Schläuche oder Rohre mit der für die Kühlung vorgesehenen Flüssigkeit, insbesondere Wasser oder Kraftstoff, der Kühleinrichtung zugeleitet und aus dieser abgeleitet werden können.

Wie gut aus der perspektivischen Unteransicht von Figur 2 erkennbar, weist der Kühlkanal 12 an seiner Außenseite Profilanformungen 15, 16, 17, usw. auf, die zur Wärmeleitung und Versteifung des Bodenabschnitts 10 beitragen. Der Bodenabschnitt 10 ist damit als Kühlplatte ausgebildet.

Hergestellt ist der Bodenabschnitt mittels Spritzguss, vorzugsweise Druckguss, wobei die Geometrie des Kühlkanals 12 während des Gussvorgangs mittels zweier Schieber, welche sich in der Mitte treffen, erzeugt wird. Hierdurch wird vorteilhaft die Dichtheit des Kühlkanals 12 bereits bei der Fertigung im ersten Fertigungsschritt erzielt.

Der Kühlkanal 12 hat bevorzugt einen runden Querschnitt. Der Querschnitt kann alternativ auch oval, annähernd quadratisch oder rechteckig oder in sonst einer leicht herstellbaren Form ausgewählt sein, die mit einer großen Oberfläche die Wärmeübertragungsfähigkeit einerseits und die mechanische Steifigkeit andererseits begünstigen.

Alternativ können statt eines Kühlkanals 12 in dem Bodenabschnitt bzw. der Kühlplatte auch mehrere separate Kühlkanäle gebildet sein, die entweder separat angeschlossen oder durch eine zusätzliche Querbohrung verbunden sind. Durch den Kühlkanal 12 bzw. mehrere Kühlkanäle wird gleichzeitig der Bodenabschnitt 10 und damit auch das Gehäuse versteift, woraus auch eine Verbesserung der Schütteleigenschaft resultiert.

Zu einer guten und effektiven Kühlleistung trägt ferner bei, dass der Querschnitt des Kühlkanals 12 für einen hohen Flüssigkeitsdurchsatz und damit auch eine gute Wärmeabfuhr dimensioniert werden kann.

## Patentansprüche

1. Gehäuse für elektronische Steuergeräte, insbesondere in Kraftfahrzeugen, mit einem Bodenabschnitt (10) zur Befestigung der elektronischen Steuergeräte, wobei der Bodenabschnitt (10) als Kühlplatte ausgebildet ist, und mit einer Kühleinrichtung (12), die als Kühlkanal ausgebildet ist, durch den mittels einer durchströmenden Flüssigkeit Wärme aus dem Gehäuse abführbar ist, **dadurch gekennzeichnet, dass** der Kühlkanal (12) in den Bodenabschnitt (10) integriert ist und einstückig mit dem Bodenabschnitt (10) ausgebildet ist.

2. Gehäuse nach Anspruch 1, **dadurch gekennzeichnet, dass** der Kühlkanal (12) an seiner Außenseite mit Profilanformungen (15, 16, 17) zur Wärmeleitung und Versteifung des Bodenabschnitts (10) versehen ist.

3. Gehäuse nach Anspruch 1 oder 2, **dadurch gekennzeichnet, dass** der Kühlkanal (12) an gegenüberliegenden Seiten des Bodenabschnitts (10) mündet, und damit den Bodenabschnitt versteift.

4. Gehäuse nach einem der Ansprüche 1 bis 3, **dadurch gekennzeichnet, dass** der Kühlkanal (12) den Bodenabschnitt (10) geradlinig durchtritt.

5. Gehäuse nach einem der Ansprüche 1 bis 4, **dadurch gekennzeichnet, dass** der Kühlkanal (12) einen runden Querschnitt aufweist.

6. Gehäuse nach einem der Ansprüche 1 bis 5, **dadurch gekennzeichnet, dass** der Einlass des Kühlkanals (12) in dem Bodenabschnitt (10) und der Auslass des Kühlkanals (12) aus dem Bodenabschnitt (10) Anschlussgewindestutzen (13, 14) aufweisen.

7. Gehäuse nach einem der Ansprüche 1 bis 6, **dadurch gekennzeichnet, dass** in der Kühlplatte separate Kühlkanäle (12) gebildet sind.

8. Gehäuse nach Anspruch 7, **dadurch gekennzeichnet, dass** die separaten Kühlkanäle (12) durch mindestens eine separate Querbohrung verbunden sind.

9. Gehäuse nach einem der vorangehenden Ansprüche, **dadurch gekennzeichnet, dass** der Bodenabschnitt mittels Spritzguss, vorzugsweise Druckguss, hergestellt ist.

## Claims

1. Housing for electronic control devices, particularly in motor vehicles, with a base section (10) for fixing the electronic control devices, the base section (10) being formed as a cooling plate, and with a cooling device (12), which, is formed as a cooling channel, through which heat can be removed from the housing by means of a liquid flowing through, **characterized in that** the cooling channel (12) is integrated in the base section (10) and is formed in one piece with the base section (10).

2. Housing according to Claim 1, **characterized in that** the cooling channel (12) is provided on its outer side with profiled formations (15, 16, 17) for heat conduction and stiffening of the base section (10).

3. Housing according to Claim 1 or 2, **characterized in that** the cooling channel (12) opens out on opposite sides of the base section (10), and thereby stiffens the base section.

4. Housing according to one of Claims 1 to 3, **characterized in that** the cooling channel (12) passes through the base section (10) in a straight line.

5. Housing according to one of Claims 1 to 4, **characterized in that** the cooling channel (12) has a round cross section.

6. Housing according to one of Claims 1 to 5, **characterized in that** the inlet of the cooling channel (12) in the base section (10) and the outlet of the cooling channel (12) from the base section (10) have threaded connection pieces (13, 14).

7. Housing according to one of Claims 1 to 6, **characterized in that** separate cooling channels (12) are formed in the cooling plate.

8. Housing according to Claim 7, **characterized in that** the separate cooling channels (12) are connected by at least one separate cross-bore.

9. Housing according to one of the preceding claims, **characterized in that** the base section is produced by means of injection diecasting, preferably pressure diecasting.

## Revendications

1. Boîtier pour appareils de commande électroniques, notamment dans des véhicules automobiles, comprenant une portion de fond (10) pour la fixation des appareils de commande électroniques, la portion de fond (10) étant réalisée sous forme de plaque de refroidissement, et comprenant un dispositif de refroidissement (12), qui est réalisé sous forme de canal de refroidissement, à travers lequel de la chaleur peut être évacuée hors du boîtier au moyen d'une circulation de liquide, **caractérisé en ce que** le canal de refroidissement (12) est intégré dans la portion de fond (10) et est réalisé d'une seule pièce avec la portion de fond (10).

2. Boîtier selon la revendication 1, **caractérisé en ce que** le canal de refroidissement (12) est pourvu sur son côté extérieur de formations profilées (15, 16, 17) pour la conduction thermique et le renforcement de la portion de fond (10).

3. Boîtier selon la revendication 1 ou 2, **caractérisé en ce que** le canal de refroidissement (12) débouche sur des côtés opposés de la portion de fond (10), et renforce ainsi la portion de fond.

4. Boîtier selon l'une quelconque des revendications 1 à 3, **caractérisé en ce que** le canal de refroidissement (12) traverse la portion de fond (10) en ligne droite.

5. Boîtier selon l'une quelconque des revendications 1 à 4, **caractérisé en ce que** le canal de refroidissement (12) présente une section transversale circulaire.

6. Boîtier selon l'une quelconque des revendications 1 à 5, **caractérisé en ce que** l'entrée du canal de refroidissement (12) dans la portion de fond (10) et la sortie du canal de refroidissement (12) hors de la portion de fond (10) présentent des tubulures filetées de raccordement (13, 14).

7. Boîtier selon l'une quelconque des revendications 1 à 6, **caractérisé en ce que** des canaux de refroidissement séparés (12) sont formés dans la plaque de refroidissement.

8. Boîtier selon la revendication 7, **caractérisé en ce que** les canaux de refroidissement séparés (12) sont connectés par au moins un alésage transversal séparé.

9. Boîtier selon l'une quelconque des revendications précédentes, **caractérisé en ce que** la portion de fond est fabriquée par moulage par injection, de préférence par moulage sous pression.
